# EUROPEAN PATENT APPLICATION

(11) **EP 4 464 626 A1**
(43) Date of publication of application: **20.11.2024**
(21) Application number: 23778806.2
(22) Date of filing: 27.01.2023
(51) Int. Cl.: B65G 1/04

(54) **CONVEYANCE SYSTEM**

(30) Priority: 29.03.2022 JP 2022054012
(71) Applicant: Murata Machinery, Ltd., Kyoto-shi, Kyoto 601-8326 (JP)
(72) Inventor: KITAMURA Wataru, Inuyama-shi, Aichi 484-8502 (JP)
(74) Representative: Stöckeler, Ferdinand
(86) International application number: PCT/JP2023/002713
(87) International publication number: WO 2023/188769

(57) **Abstract**

The transport system includes a plurality of transport vehicles, a traveling track, a loading portion, and a controller. The traveling track includes a plurality of intra-section tracks and a connecting track connecting the intra-section tracks. Each of the intra-section tracks includes an entrance area for entering the intra-section track and an exit area for exiting the intra-section track. The loading portion includes a first loading portion and a second loading portion. In a case in which the article is to be transported from the first loading portion, at the time of traffic restriction in which traffic restriction of a predetermined level or more is occurring in at least one of the entrance area and the exit area of the first intra-section track, the controller causes the transport vehicles to perform transport for transporting the article from the first loading portion via the second loading portion.

## Description

### Technical Field

An aspect of the present invention relates to a transport system.

### Background Art

As a technique related to a transport system, for example, Patent Literature 1 discloses a system including a plurality of automated traveling vehicles (transport vehicles) configured to travel on a traveling track and transport an article, a station on which the article is to be placed, and a controller configured to control the automated traveling vehicles. In this transport system, the traveling track includes a plurality of intra-section tracks (which are called intra-bay tracks) and a connecting track (which is called an inter-bay track) connecting the intra-section tracks. Each automated traveling vehicle passes through the connecting track, for example, when transporting an article from a station along one intra-section track to a station along another intra-section track.

### Citation List

### Patent Literature

[Patent Literature 1] Japanese Unexamined Patent Publication No. 2018-36867

### Summary of Invention

### Technical Problem

In such a transport system as described above, trouble, traffic congestion, or the like may occur at an entrance area for entering an intra-section track and at an exit area for exiting the intra-section track. In this case, traffic between this intra-section track and the other intra-section tracks may be obstructed, and the efficiency of transporting articles may be reduced.

In view of this, it is an object of an aspect of the present invention to provide a transport system that can improve the efficiency of transporting articles.

### Solution to Problem

(1) A transport system according to an aspect of the present invention is a transport system including: a plurality of transport vehicles each configured to transport an article; a traveling track on which the transport vehicles travel; a loading portion on which the article is placed; and a controller to control the transport vehicles. The traveling track includes a plurality of intra-section tracks and a connecting track connecting the intra-section tracks. Each of the intra-section tracks includes an entrance area for entering the intra-section track and an exit area for exiting the intra-section track. The loading portion includes: a first loading portion being the loading portion onto and from which the transport vehicle present on a first intra-section track of the intra-section tracks is able to transfer the article; and a second loading portion being the loading portion onto and from which the transport vehicle present on the first intra-section track is able to transfer the article and also onto and from which the transport vehicle present on a second intra-section track of the intra-section tracks is able to transfer the article. In a case in which the article is to be transported from the first loading portion or the article is to be transported to the first loading portion, at the time of traffic restriction in which traffic restriction of a predetermined level or more is occurring in at least one of the entrance area and the exit area of the first intra-section track, the controller causes the transport vehicles to perform transport for transporting the article from the first loading portion via the second loading portion or transport for transporting the article to the first loading portion via the second loading portion.
   In this transport system, even when traffic is restricted in at least one of the entrance area and the exit area of the first intra-section track (hereinafter simply referred to as "at the time of traffic restriction"), the transport of the article from the first intra-section track and to the first intra-section track can be smoothly performed via the second loading portion. This can improve the efficiency of transporting the article.
(2) In the transport system described in (1) above, at the time of traffic restriction in the case in which the article is to be transported from the first loading portion or the article is to be transported to the first loading portion, the controller may divide and assign, to the transport vehicles, a transport instruction to transport the article from the first loading portion via the second loading portion or a transport instruction to transport the article to the first loading portion via the second loading portion. In this case, smooth transport of the article at the time of traffic restriction can be specifically performed.
(3) In the transport system described in (1) or (2) above, at the time of traffic restriction in the case in which the article is to be transported from the first loading portion, the controller may assign a transport instruction to transport the article from the first loading portion to the second loading portion to the transport vehicle present on the first intra-section track, and also may assign a transport instruction to transport the article from the second loading portion to the transport vehicle present on a track other than the first intra-section track. In this case, at the time of traffic restriction in the first intra-section track, the respective transport instructions can be assigned to different transport vehicles to perform the transport of the article from the first loading portion.
(4) In the transport system described in any one of (1) to (3) above, at the time of traffic restriction in the case in which the article is to be transported to the first loading portion, the controller may assign a transport instruction to transport the article to the second loading portion to the transport vehicle present on a track other than the first intra-section track, and also may assign a transport instruction to transport the article from the second loading portion to the first loading portion to the transport vehicle present on the first intra-section track. In this case, at the time of traffic restriction in the first intra-section track, the respective transport instructions can each be assigned to different transport vehicles to perform the transport of the article to the first loading portion.
(5) In the transport system described in any one of (1) to (4) above, the intra-section tracks may be disposed side by side in one direction, and the first intra-section track and the second intra-section track may be adjacent to each other. In this case, the transport of the article via the second loading portion can be performed between the first intra-section track and the second intra-section track that are disposed side by side so as to be adjacent to each other in one direction.
(6) In the transport system described in any one of (1) to (5) above, each transport vehicle may include a transfer device including: an article holding unit configured to hold the article; a lifting drive unit configured to raise and lower the article holding unit; and a lateral feed mechanism configured to slide and move the lifting drive unit in a horizontal direction, and may transfer the article onto and from the second loading portion by causing the lateral feed mechanism to slide and move the lifting drive unit and the article holding unit. In this case, the article can be transferred onto and from a loading portion horizontally away from the intra-section tracks.
(7) In the transport system described in any one of (1) to (6) above, the traveling track may be a grid-patterned track. In this case, what is called a grid system can be configured. By this configuration, traveling paths for the transport vehicle can be selected easily and flexibly, whereby traffic congestion can be prevented and transport efficiency can be further improved.
(8) In the transport system described in (7) above, the entrance area may correspond to a grid cell in the first intra-section track that is passed through when the first intra-section track is entered, and the exit area may correspond to a grid cell in the first intra-section track that is passed through when the first intra-section track is exited. The controller may determine a level of traffic restriction based on a ratio of the number of available grid cells corresponding to the entrance area to the number of all grid cells corresponding to the entrance area and a ratio of the number of available grid cells corresponding to the exit area to the number of all grid cells corresponding to the exit area. In this case, whether the first intra-section track is at the time of traffic restriction in the grid system can be specifically determined.
(9) In the transport system described in any one of (1) to (8) above, the loading portion may include a third loading portion being the loading portion onto and from which the transport vehicle present on the second intra-section track is able to transfer the article and also onto and from which the transport vehicle present on a third intra-section track of the intra-section tracks is able to transfer the article. In the case in which the article is to be transported from the first loading portion or the article is to be transported to the first loading portion, when traffic restriction of a predetermined level or more is further occurring in at least one of the entrance area and the exit area of the second intra-section track at the time of traffic restriction, the controller may cause the transport vehicles to perform transport for transporting the article from the first loading portion via the second loading portion and the third loading portion or transport for transporting the article to the first loading portion via the second loading portion and the third loading portion. In this case, the article can be transported via the second loading portion and the third loading portion even at the time of traffic restriction in the first intra-section track and the second intra-section track.
(10) In the transport system described in any one of (1) to (9) above, at the time of traffic restriction in the case in which the article is to be transported from the first loading portion or the article is to be transported to the first loading portion, the controller may perform an entry/exit restriction process of restricting entry and exit of the transport vehicles into and from the first intra-section track such that the number of the transport vehicles present on the first intra-section track becomes closer to a predetermined number set in advance and, after performing the entry/exit restriction process, may cause the transport vehicles to the transport for transporting the article from the first loading portion via the second loading portion or the transport for transporting the article to the first loading portion via the second loading portion. By this control, while the number of the transport vehicles present on the first intra-section track is being controlled, the article can be transported from the first loading portion via the second loading portion or the article can be transported to the first loading portion via the second loading portion.
(11) In the transport system described in any one of (1) to (10) above, the first intra-section track may include a delivery track disposed to extend towards the second intra-section track in plan view, the second intra-section track may include a delivery track disposed to extend towards the first intra-section track in plan view, and the second loading portion may be the loading portion onto and from which the transport vehicle present on the delivery track of the first intra-section track is able to transfer the article and also onto and from which the transport vehicle present on the delivery track of the second intra-section track is able to transfer the article. In this case, by using an emergency track for the first intra-section track and the second intra-section track, the article can be transported via the second loading portion between the first intra-section track and the second intra-section track.

### Advantageous Effects of Invention

According to an aspect of the present invention, it is possible to provide the transport system that can improve the efficiency of transporting articles.

### Brief Description of Drawings

[FIG. 1] FIG. 1 is a schematic plan view illustrating an example of a transport system according to an embodiment.
[FIG. 2] FIG. 2 is a perspective view illustrating a part of the transport system in FIG. 1.
[FIG. 3] FIG. 3 is a perspective view illustrating a transport vehicle in FIG. 1.
[FIG. 4] FIG. 4 is a side view illustrating the transport vehicle in FIG. 1.
[FIG. 5] FIG. 5 is a block diagram illustrating a configuration of the transport system in FIG. 1.
[FIG. 6] FIG. 6 is a perspective view illustrating a delivery buffer in FIG. 1.
[FIG. 7] FIG. 7 is a flowchart illustrating an example of processes in the transport system in FIG. 7.
[FIG. 8] FIG. 8 is a schematic plan view for describing an example of processes in the transport system of FIG. 1.
[FIG. 9] FIG. 9 is another schematic plan view for describing an example of processes in the transport system of FIG. 1.
[FIG. 10] FIG. 10 is a schematic plan view for describing other processes in the transport system of FIG. 1.

### Description of Embodiments

An embodiment will now be described with reference to the drawings. In the description of the drawings, like elements are designated by like reference signs, and duplicate description is omitted.

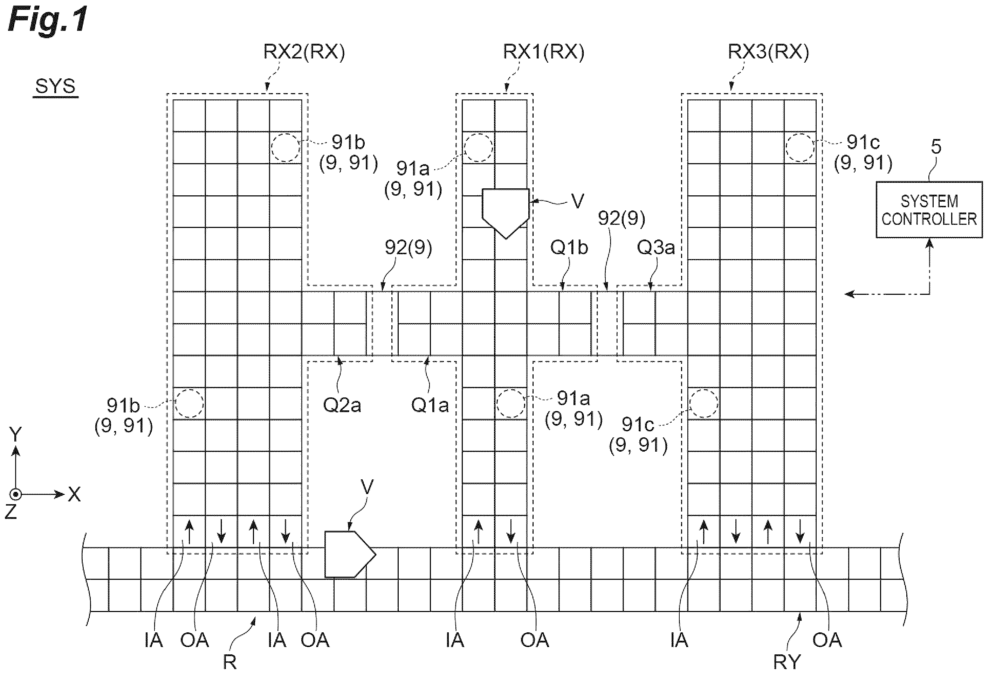

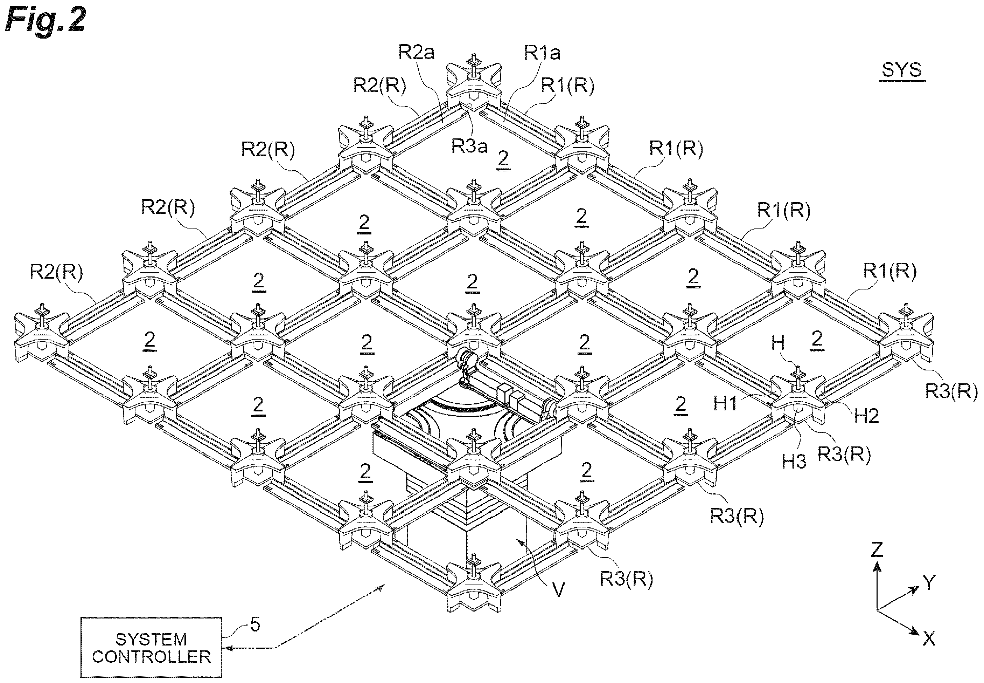

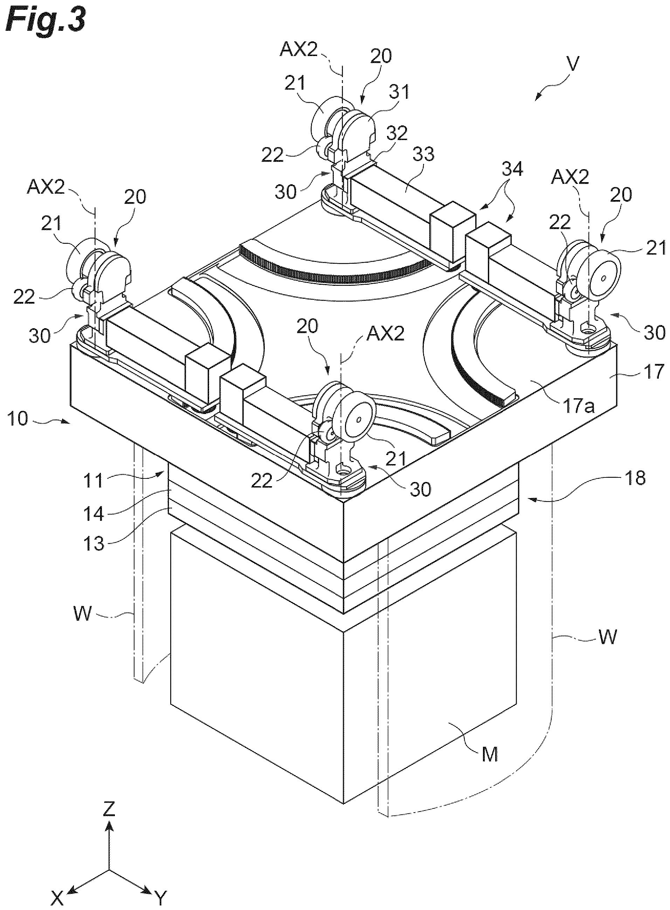

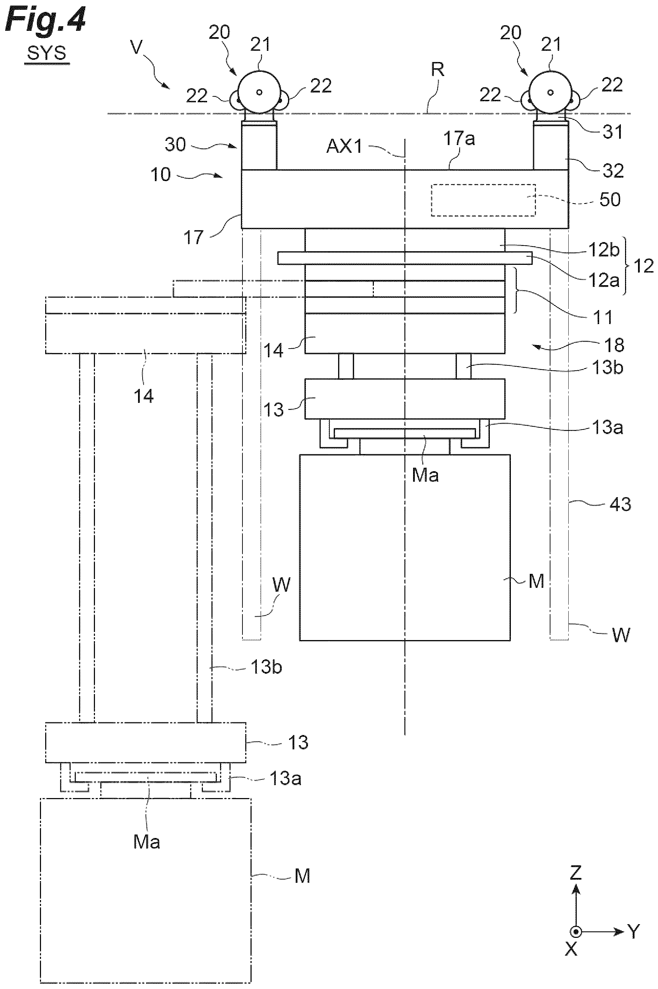

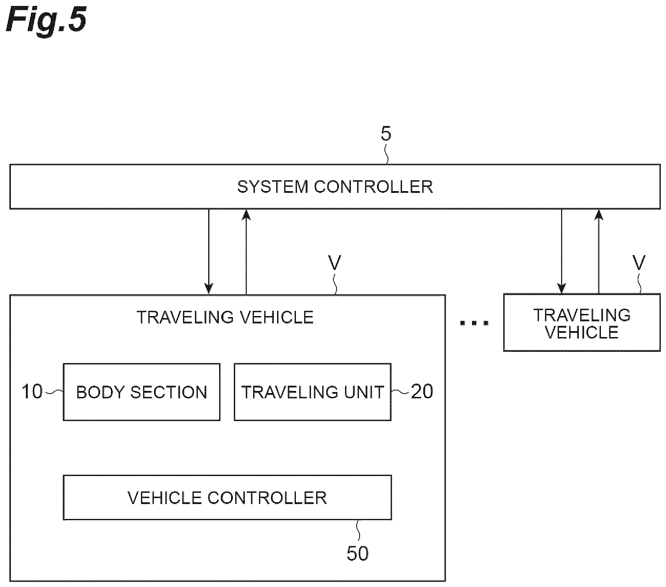

FIG. 1 is a schematic plan view illustrating a transport system SYS. FIG. 2 is a perspective view illustrating a part of the transport system SYS. FIG. 3 is a perspective view illustrating a transport vehicle V. FIG. 4 is a side view illustrating the transport vehicle V. FIG. 5 is a block diagram illustrating the transport system SYS in FIG. 1. In the following description, one direction along a horizontal plane is denoted as the X direction, a direction orthogonal to the X direction and along the horizontal plane is denoted as the Y direction, and the vertical direction is denoted as the Z direction.

As illustrated in FIGS. 1 and 2, the transport system SYS is a grid system for transporting an article M by a transport vehicle V in a clean room of a semiconductor manufacturing factory, for example. The transport system SYS includes a plurality of the transport vehicles V, a rail (traveling track) R on which the transport vehicles V travel, and a loading portion 9 on which an article M is placed. The transport vehicles V move along a rail R of the transport system SYS. The rail R is a traveling path for the transport vehicles V. Each transport vehicle V moves along the rail R of the transport system SYS, and transports an article M such as a FOUP configured to accommodate semiconductor wafers or a reticle pod configured to accommodate reticles. The transport vehicle V may be referred to as an overhead hoist transport, a traveling transport vehicle, or a traveling vehicle.

The rail R is installed on a ceiling of a building such as a clean room or near the ceiling. The rail R is an example of a form of a traveling track. The rail R is a grid-patterned track arranged in a grid pattern in plan view. The rail R extends along a horizontal direction and is suspended. The rail R is a grid-patterned rail including a plurality of first rails R1, a plurality of second rails R2, and a plurality of intersection parts R3.

The first rails R1 each extend along the X direction. The second rails R2 each extend along the Y direction. The rail R is formed in a grid pattern in plan view by the first rails R1 and the second rails R2. The rail R forms a plurality of matrix elements with the first rails R1 and the second rails R2. The intersection parts R3 are disposed at portions corresponding to intersections of the first rails R1 and the second rails R2. Each intersection part R3 is adjacent to the corresponding first rails R1 in the X direction and adjacent to the corresponding second rails R2 in the Y direction. The intersection parts R3 connect each first rail R1 to the corresponding second rail R2, connect the first rails R1 to each other, and connect the second rails R2 to each other.

In the rail R, the first rails R1 and the second rails R2 are provided in orthogonal directions, whereby a plurality of grid cells 2 are arranged adjacent to each other in plan view. One grid cell 2 corresponds to one matrix element and is a rectangular area surrounded by two first rails R1 adjacent in the Y direction and two second rails R2 adjacent in the X direction in plan view. In FIG. 2, part of the rail R is illustrated, and the same configuration of the rail R may be formed continuously in the X direction and the Y direction from the illustrated configuration.

The first rails R1, the second rails R2, and the intersection parts R3 are suspended from a ceiling (not illustrated) by suspending members H. Each suspending member H has first portions H1 for suspending first rails R1, second portions H2 for suspending second rails R2, and a third portion H3 for suspending an intersection part R3. The first portions H1 and the second portions H2 are each formed at two locations with the third portion H3 interposed therebetween.

The first rails R1, the second rails R2, and the intersection parts R3 have traveling surfaces R1a, R2a, and R3a, respectively, on which traveling wheels 21 (described later) of the transport vehicle V travel. A gap is formed between each first rail R1 and the corresponding intersection part R3 and between each second rail R2 and the corresponding intersection part R3, respectively. The gaps between the first rail R1 and the intersection part R3 and between the second rail R2 and the intersection part R3 are spaces through which a coupling section 30, described later, which is a part of a transport vehicle V, passes when the transport vehicle V travels on a first rail R1 and crosses a second rail R2, or when it travels on a second rail R2 and crosses a first rail R1. Thus, the gaps between the first rail R1 and the intersection part R3 and between the second rail R2 and the intersection part R3 are formed in a width through which the coupling section 30 can pass. The first rails R1, the second rails R2, and the intersection parts R3 are provided along the same horizontal plane.

The transport system SYS includes a communication system (not illustrated). The communication system is used for communication between the transport vehicle V and the system controller 5. The transport vehicle V and the system controller 5 are connected in a manner capable of communicating with each other via the communication system.

The following describes a configuration of the transport vehicle V. As illustrated in FIGS. 3, 4, and 5, the transport vehicle V is provided to be able to travel along the rail R. The transport vehicle V includes a body section 10, a traveling unit 20, the coupling section 30, and a transport vehicle controller 50.

The body section 10 is disposed below the rail R. The body section 10 is formed in a rectangular shape, for example, in plan view. The body section 10 is formed to have dimensions that fit into one grid cell 2 (see FIG. 2) in the rail R in plan view. This provides space for the transport vehicle V to pass another one traveling on the adjacent first rail R1 or the adjacent second rail R2. The body section 10 includes an upper unit 17 and a transfer device 18. The upper unit 17 is suspended from the traveling unit 20 with the coupling section 30 interposed therebetween. The upper unit 17 is rectangular in plan view, for example, and has four corners on an upper surface 17a thereof.

The body section 10 includes, on each of its four corners, a traveling wheel 21, the coupling section 30, and a direction-changing mechanism 34. In this configuration, the traveling wheels 21 disposed at the four corners of the body section 10 allow the body section 10 to be suspended stably and the body section 10 to travel stably.

The transfer device 18 moves along the horizontal direction with respect to the traveling unit 20 to transfer an article onto and from the loading portion 9. The transfer device 18 is provided below the upper unit 17. The transfer device 18 can rotate about a rotation axis AX1 in the Z direction. The transfer device 18 includes an article holding unit 13 configured to hold an article M below the rail R, a lifting drive unit 14 configured to raise and lower the article holding unit 13 in the vertical direction, a lateral feed mechanism 11 configured to slide and move the lifting drive unit 14 in the horizontal direction, and a turning unit 12 configured to hold the lateral feed mechanism 11.

The article holding unit 13 grips a flange Ma of an article M, thereby suspending and holding the article M. The article holding unit 13 is, for example, a chuck including claws 13a that can move horizontally. By causing the claws 13a to proceed to below the flange Ma of the article M and raising the article holding unit 13, the article M is held. The article holding unit 13 is connected to suspending members 13b such as wires or belts.

The lifting drive unit 14 is a hoist, for example, which lowers the article holding unit 13 by paying out the suspending members 13b, and raises the article holding unit 13 by winding the suspending members 13b. The lifting drive unit 14 is controlled by the transport vehicle controller 50 to lower or raise the article holding unit 13 at a predetermined speed. The lifting drive unit 14 is controlled by the transport vehicle controller 50 to hold the article holding unit 13 at a target height.

The lateral feed mechanism 11 includes a plurality of movable plates disposed in a manner stacked in the Z direction, for example. To the lowermost movable plate, the lifting drive unit 14 is attached. In the lateral feed mechanism 11, the movable plates move in a direction perpendicular to the traveling direction of the transport vehicle V in the horizontal plane, and the lifting drive unit 14 attached to the lowermost movable plate and the article holding unit 13 are fed (slid and moved) in the direction perpendicular to the traveling direction of the transport vehicle V.

The turning unit 12 is provided between the lateral feed mechanism 11 and the upper unit 17. The turning unit 12 includes a turning member 12a and a turning drive unit 12b. The turning member 12a is provided to be able to turn about an axis in the Z direction. The turning member 12a supports the lateral feed mechanism 11. The turning drive unit 12b, for which an electric motor or the like is used, turns the turning member 12a about the rotation axis AX1. The turning unit 12 turns the turning member 12a by the driving force from the turning drive unit 12b, thereby being able to rotate the lateral feed mechanism 11 (the lifting drive unit 14 and the article holding unit 13) about the rotation axis AX1. The transport vehicle V can deliver and receive an article M to and from the loading portion 9 by using the transfer device 18.

As illustrated in FIGS. 3 and 4, the transport vehicle V may be provided with a cover W. The cover W surrounds the transfer device 18 and the article M held by the transfer device 18. The cover W has a tubular shape that is open at the lower end thereof, and has such a shape that a portion thereof through which the movable plates of the lateral feed mechanism 11 protrude is recessed. The cover W, the upper end of which is attached to the turning member 12a of the turning unit 12, turns about the rotation axis AX1 as the turning member 12a turns.

The traveling unit 20 includes the traveling wheels 21 and auxiliary wheels 22. The traveling wheels 21 are disposed at the respective four corners of the upper surface 17a of the upper unit 17 (the body section 10). Each traveling wheel 21 is attached to an axle provided to the corresponding coupling section 30. Each traveling wheel 21 is rotationally driven by the driving force of a traveling drive unit 33. Each traveling wheel 21 rolls on the rail R. The respective traveling wheels 21 roll on the traveling surfaces R1a, R2a, R3a of the first rails R1, the second rails R2, and the intersection parts R3, thereby causing the transport vehicle V to travel. Herein, all of the four traveling wheels 21 do not necessarily have to be rotationally driven by the driving force of the traveling drive unit 33, and some of the four traveling wheels 21 may be configured to be rotationally driven.

Each traveling wheel 21 is provided to be able to pivot in a ΘZ direction about a pivot axis AX2. The traveling wheel 21 pivots in the ΘZ direction by the corresponding direction-changing mechanism 34 described later, and consequently can change the traveling direction of the transport vehicle V. The auxiliary wheels 22 are disposed each in front of and to the rear of the traveling wheel 21 in the traveling direction. Each of the auxiliary wheels 22 can rotate about the axis of the axle that is parallel or substantially parallel along the XY plane in the same manner as the traveling wheel 21. The lower ends of the auxiliary wheels 22 are set higher than the lower end of the traveling wheel 21. Thus, when the traveling wheel 21 is traveling on the traveling surfaces R1a, R2a, R3a, the auxiliary wheels 22 do not come into contact with the traveling surfaces R1a, R2a, R3a. When the traveling wheel 21 passes over the gaps between the first rail R1 and the intersection part R3 and between the second rail R2 and the intersection part R3, the auxiliary wheels 22 come into contact with the traveling surfaces R1a, R2a, R3a to prevent the traveling wheel 21 from falling. Herein, two auxiliary wheels 22 do not necessarily have to be provided to one traveling wheel 21. For example, one auxiliary wheel 22 may be provided on one traveling wheel 21, or no auxiliary wheel 22 may be provided.

As illustrated in FIG. 3, the coupling sections 30 couple the upper unit 17 of the body section 10 to the traveling unit 20. The coupling sections 30 are provided at the respective four corners of the upper surface 17a of the upper unit 17 (the body section 10). By these coupling sections 30, the body section 10 is suspended from the traveling unit 20 and disposed below the rail R. Each coupling section 30 includes a support member 31 and a connecting member 32. The support member 31 rotatably supports the rotating shaft of the corresponding traveling wheel 21 and the rotating shafts of the corresponding auxiliary wheels 22. The support member 31 maintains the relative position between the traveling wheel 21 and the auxiliary wheels 22. The support member 31 is formed in a platelike shape, for example, and is formed to have a thickness capable of passing through the gaps between the first rail R1 and the intersection part R3 and between the second rail R2 and the intersection part R3.

The connecting member 32 extends downward from the support member 31 and is coupled to the upper surface 17a of the upper unit 17 to hold the upper unit 17. The connecting member 32 includes a transmission mechanism configured to transmit the driving force of the traveling drive unit 33, described later, to the traveling wheel 21. This transmission mechanism may have a configuration using a chain or a belt, or may have a configuration using a gear train. The connecting member 32 is provided to be able to pivot in the ΘZ direction about the pivot axis AX2. This connecting member 32 pivots about the pivot axis AX2, thereby being able to pivot the traveling wheel 21 in the ΘZ direction about the pivot axis AX2 with the support member 31 interposed therebetween.

Each coupling section 30 (see FIG. 3) is provided with the traveling drive unit 33 and the direction-changing mechanism 34. The traveling drive unit 33 is mounted on the corresponding connecting member 32. The traveling drive unit 33 is a driving source configured to drive the traveling wheel 21 and, for example, an electric motor is used therefor. Each of the four traveling wheels 21 is a driving wheel driven by the corresponding traveling drive unit 33. The four traveling wheels 21 are controlled by the transport vehicle controller 50 to have the same rotation speed.

The direction-changing mechanism 34 pivots the traveling wheel 21 in the direction ΘZ about the pivot axis AX2 by pivoting the connecting member 32 of the coupling section 30 about the pivot axis AX2. By pivoting the traveling wheel 21 in the θZ direction, the transport vehicle V can be turned (switched from a first state in which the traveling direction thereof is the X direction to a second state in which the traveling direction is the Y direction, or from the second state in which the traveling direction is the Y direction to the first state in which the traveling direction is the X direction). By this pivoting of the direction-changing mechanism 34, each of the traveling wheels 21 and the auxiliary wheels 22 disposed at the four corners of the upper surface 17a is pivoted within a range of 90 degrees in the θZ direction about the pivot axis AX2. The driving of the direction-changing mechanism 34 is controlled by the transport vehicle controller 50. By pivoting the traveling wheels 21 and the auxiliary wheels 22, the traveling wheels 21 shift from a state of being in contact with one of the first rails R1 and the second rails R2 to a state of being in contact with the other. This allows the transport vehicle V to switch between the first state in which the traveling direction thereof is the X direction and the second state in which the traveling direction is the Y direction, that is, the transport vehicle V can be turned.

The transport vehicle controller 50 collectively controls the transport vehicle V. The transport vehicle controller 50 is a computer including a central processing unit (CPU), a read only memory (ROM), and a random access memory (RAM). The transport vehicle controller 50 can be configured, for example, as software such that a program stored in the ROM is loaded into the RAM to be executed by the CPU. The transport vehicle controller 50 may be configured as hardware such as an electronic circuit. The transport vehicle controller 50 may be configured with a single device, or may be configured with a plurality of devices. If it is configured with a plurality of devices, they are connected via a communication network such as the Internet or an intranet to logically construct a single transport vehicle controller 50. The transport vehicle controller 50 is provided to the body section 10 in the present embodiment (see FIG. 4), but may be provided outside the body section 10.

The transport vehicle controller 50 controls traveling of the transport vehicle V on the basis of transport instructions. The transport vehicle controller 50 controls the traveling of the transport vehicle V by controlling the traveling drive unit 33 and the direction-changing mechanism 34, for example. The transport vehicle controller 50 controls, for example, traveling speed, operations related to stopping, and operations related to changing directions.

The transport vehicle controller 50 controls transfer operation of the transport vehicle V on the basis of transport instructions. The transport vehicle controller 50 controls the transfer operation of the transport vehicle V by controlling the transfer device 18, for example. The transport vehicle controller 50 controls operation of gripping an article M to be placed on a loading portion 9, and operation of unloading the held article M onto the loading portion 9. The transport vehicle controller 50 generates and updates state information (not illustrated) periodically. The state information is stored in a storage unit 51. The transport vehicle controller 50 transmits the state information to the system controller 5. The state information includes, for example, information on the current position of the transport vehicle V, information indicating the current state of the transport vehicle V such as normal or abnormal, the amount of charge of the transport vehicle V, and information on the state (execution in progress, execution completed, or execution failed) of various instructions such as transport instructions executed by the transport vehicle V.

The system controller 5 is a computer including a CPU, a ROM, and a RAM. The system controller 5 can be configured, for example, as software such that a program stored in the ROM is loaded into the RAM to be executed by the CPU. The system controller 5 may be configured as hardware such as an electronic circuit. The system controller 5 may be configured with a single device or a plurality of devices. When it is configured with a plurality of devices, they are connected via a communication network such as the Internet or an intranet to logically construct a single system controller 5. At least some of the various controls of the system controller 5 may be performed by the transport vehicle controller 50.

The system controller 5 controls the transport vehicles V. The system controller 5 selects any one of the transport vehicles V that can transport an article M, and assigns the transport instruction to the selected transport vehicle V. The transport instruction includes a traveling instruction for the transport vehicle V to travel, and an instruction to grab an article M placed on a loading portion 9 or an instruction to unload the article M being held onto the loading portion 9.

The loading portion 9 is a portion on which an article M is to be placed. The loading portion 9 includes a load port 91. The load port 91 is a loading portion for delivering and receiving an article M to and from a semiconductor processing device (not illustrated) including exposure equipment, cleaning equipment, deposition equipment, lithography equipment, etching equipment, thermal processing equipment, and planarization equipment. Herein, the processing device is not limited to a particular one, and may be a device of various types. The load port 91 is disposed along the rail R below the rail R, for example. The load port 91 may be a loading portion for delivering and receiving an article M to and from, for example, a stocker (automatic warehouse) configured to store the article M.

In the present embodiment herein, as illustrated in FIG. 1, the rail R includes a plurality of intra-bay rails (intra-section tracks) RX and an inter-bay rail (connecting track) RY connecting the intra-bay rails RX. The intra-bay rails RX are provided independently of each other. The intra-bay rails RX are configured not to be directly connected to each other. Each of the intra-bay rails RX includes a group of grid cells 2 (see FIG. 2). Each intra-bay rail RX includes an entrance area IA for entering the intra-bay rail RX and an exit area OA for exiting the intra-bay rail RX.

The entrance area IA is formed of one grid cell 2 that is in contact with the inter-bay rail RY in the intra-bay rail RX. In other words, the entrance area IA corresponds to a grid cell 2 of the intra-bay rail RX that is passed through when the intra-bay rail RX is entered. The exit area OA is formed of one grid cell 2 that is in contact with the inter-bay rail RY in the intra-bay rail RX, which is different from the entrance area IA. In other words, the exit area OA corresponds to a grid cell 2 of the intra-bay rail RX that is passed through when the intra-bay rail RX is exited. In each intra-bay rail RX, a transport vehicle V can enter from the entrance area IA, travel in the intra-bay rail RX, and then exit from the exit area OA. The intra-bay rails RX are not directly connected to each other, but are connected by the inter-bay rail RY. The inter-bay rail RY is disposed extending along the X direction. The inter-bay rail RY includes a group of grid cells 2.

The intra-bay rails RX are disposed side by side in one direction (the X direction, herein). The intra-bay rails RX include at least a first intra-bay rail RX1, a second intra-bay rail RX2, and a third intra-bay rail RX3. The first intra-bay rail RX1, the second intra-bay rail RX2, and the third intra-bay rail RX3 are arranged in parallel apart from each other in the X direction. The first intra-bay rail RX1 and the second intra-bay rail RX2 are adjacent (next) to each other, and the first intra-bay rail RX1 and the third intra-bay rail RX3 are adjacent (next) to each other.

The first intra-bay rail RX1 includes a delivery rail Q1a disposed to extend towards the second intra-bay rail RX2 in plan view. The first intra-bay rail RX1 includes a delivery rail Q1b disposed to extend towards the third intra-bay rail RX3 in plan view. The delivery rails (delivery tracks) Q1a and Q1b herein are configured such that two grid cells 2 are continuously aligned in the X direction and two grid cells 2 are continuously aligned in the Y direction. The delivery rails Q1a and Q1b are located directly above the processing device. The delivery rails Q1a and Q1b are tracks to be used in non-normal operation.

The second intra-bay rail RX2 includes a delivery rail (delivery track) Q2a disposed to extend towards to the first intra-bay rail RX1 in plan view. The delivery rail Q2a herein is configured such that two grid cells 2 are continuously aligned in the X direction and two grid cells 2 are continuously aligned in the Y direction. The delivery rail Q2a and the delivery rail Q1a extend to protrude toward each other in the X direction. The delivery rail Q2a is located directly above the processing unit. The delivery rail Q2a is a track to be used in non-normal operation. The third intra-bay rail RX3 includes a delivery rail (delivery track) Q3a disposed to extend towards the first intra-bay rail RX1 in plan view. The delivery rail Q3a herein is configured such that two grid cells 2 are continuously aligned in the X direction and two grid cells 2 are continuously aligned in the Y direction. The delivery rail Q3a and the delivery rail Q1b extend to protrude toward each other in the X direction. The delivery rail Q3a is located directly above the processing unit. The delivery rail Q3a is a track to be used in non-normal operation.

In the present embodiment, the loading portion 9 includes the load port 91 as described above. The load port 91 includes: first load ports 91a onto and from which a transport vehicle V present on the first intra-bay rail RX1 can transfer an article M; second load ports 91b onto and from which a transport vehicle V present on the second intra-bay rail RX2 can transfer an article M; and third load ports 91c onto and from which a transport vehicle V present on the third intra-bay rail RX3 can transfer an article M.

The loading portion 9 further includes a delivery buffer 92. The delivery buffer 92 is a loading portion on which an article M can be temporarily placed. The delivery buffer 92 is provided between the delivery rail Q1a of the first intra-bay rail RX1 and the delivery rail Q2a of the second intra-bay rail RX2 in plan view. The delivery buffer 92 is also provided between the delivery rail Q1b of the first intra-bay rail RX1 and the delivery rail Q3a of the third intra-bay rail RX3 in plan view. The delivery buffer 92 between the first intra-bay rail RX1 and the second intra-bay rail RX2 is a loading portion onto and from which a transport vehicle V present on the first intra-bay rail RX1 can transfer an article M and also a transport vehicle V present on the second intra-bay rail RX2 can transfer an article M. The delivery buffer 92 between the first intra-bay rail RX1 and the third intra-bay rail RX3 is a loading portion onto and from which a transport vehicle V present on the first intra-bay rail RX1 can transfer an article M and also a transport vehicle V present on the third intra-bay rail RX3 can transfer an article M.

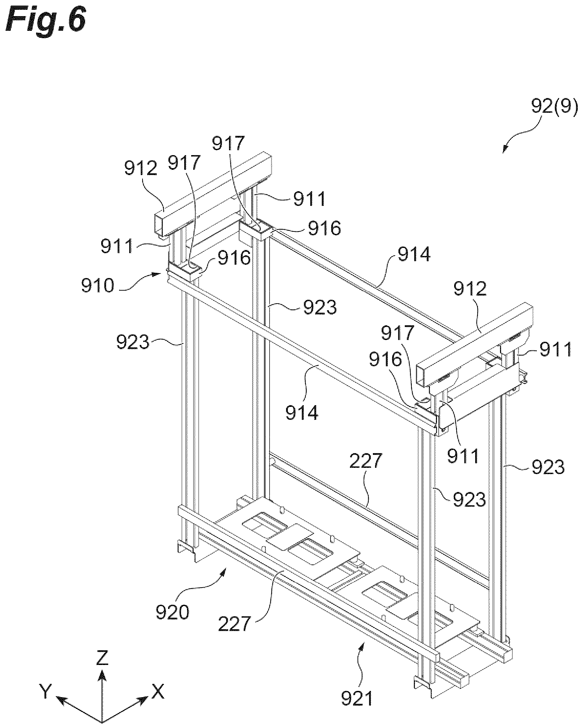

FIG. 6 is a perspective view illustrating each delivery buffer 92. As illustrated in FIGS. 1 and 6, the delivery buffer 92 is an overhead buffer (OHB). Onto and from the delivery buffer 92, a transport vehicle V can transfer an article M in the X direction and the Z direction. Each delivery buffer 92 includes a base frame 910 suspended from the ceiling, for example, and a shelf 920 attached to the base frame 910 and suspended below the base frame 910. The shelf 920, for example, can store a plurality of articles M. In the illustrated example, on the shelf 920, two articles M can be placed side by side in the Y direction. The shelf 920 is provided in a range corresponding to two grid cells 2 (see FIG. 2) that are continuously aligned in the Y direction in plan view. The shelf 920 herein is movable upward with respect to the base frame 910.

The base frame 910 includes two pairs of posts 911 disposed in a manner spaced apart in the Y direction and each extending in the Z direction, two long frames 914 laid over in the Y direction between the two pairs of posts 911, and transverse beams 912 each laid over between the upper ends of the corresponding pair of posts 911 and extending in the X direction. The shelf 920 includes two pairs of support columns 923 disposed in a manner spaced apart in the Y direction and each extending in the Z direction and a lower frame 921 fixed to the lower ends of the two pairs of support columns 923 and forming a plurality of placement surfaces. Between the lower ends of the two support columns 923 spaced apart in the Y direction, fall prevention bars 927 are laid over.

In the delivery buffer 92, the support columns 923 slide and move vertically with respect to the base frame 910. To the base frame 910, guide parts 916 fixed to the lower ends of the respective posts 911 are fixed. Each guide part 916 has a U-shape, and the lower end of the corresponding post 911 is fit into the opening of the U-shape. In each guide part 916, an insertion hole 917 penetrating in the Z direction is formed. The respective support columns 923 of the shelf 920 are inserted into the insertion holes 917 of the guide parts 916 and are guided so as to slide in the Z direction, while movement thereof in the X direction and the Y direction is restricted by the guide parts 916. For example, the posts 911 and the upper ends of the support columns 923 may be fastened by bolts or other means.

As illustrated in FIG. 1, in a case in which an article M is to be transported from a first load port 91a or the article M is to be transported to the first load port 91a, at the time of traffic restriction in which traffic restriction of a predetermined level or more is occurring in at least one of the entrance area IA and the exit area OA of the first intra-bay rail RX1 (hereinafter, also simply referred to as "traffic restriction"), the system controller 5 divides and assigns, to a plurality of transport vehicles V, a transport instruction to transport the article M from the first load port 91A via a delivery buffer 92 or a transport instruction to transport the article M to the first load port 91A via the delivery buffer 92. In this case, the first intra-bay rail RX1 corresponds to the first intra-section track, the second or third intra-bay rail RX2 or RX3 corresponds to the second intra-section track, the first load port 91a corresponds to the first loading portion, and the delivery buffer 92 corresponds to the second loading portion.

The system controller 5 determines the level of traffic restriction at the time of traffic restriction in the first intra-bay rail RX1 on the basis of the ratio of the number of available grid cells 2 corresponding to the entrance area IA to the number of all grid cells 2 corresponding to the entrance area IA, and the ratio of the number of available grid cells 2 corresponding to the exit area OA to the number of all grid cells 2 corresponding to the exit area OA. Specifically, the system controller 5 calculates the ratio of available grid cells 2 in the entrance area IA (active ratio), and determines that traffic restriction of the predetermined level or more is occurring in the entrance area IA if the active ratio in the entrance area IA is a certain ratio set in advance or less. The system controller 5 calculates the ratio of available grid cells 2 in the exit area OA (active ratio) and determines that traffic restriction of the predetermined level or more is occurring in the exit area OA if the active ratio in the exit area OA is a certain ratio set in advance or less. At the time of traffic restriction in the first intra-bay rail RX1, the first intra-bay rail RX1 is isolated and delivery to or reception from the first load port 91a cannot be made via the entrance area IA or the exit area OA.

The system controller 5 may determine whether traffic restriction is occurring, that is, whether the respective grid cells 2 corresponding to the entrance area IA and the exit area OA are available, based on route closure information acquired by communication from an external unit (such as a host controller and a portable terminal), for example. The system controller 5 may determine whether traffic restriction is occurring based on other information. The system controller 5 may determine whether traffic restriction is occurring at system startup and when the layout of the rail R is changed. Examples of the case in which grid cells 2 corresponding to the entrance area IA and the exit area OA are not available include cases when the grid cells 2 are closed due to trouble, construction, error stop of a transport vehicle V, and maintenance.

At the time of traffic restriction in the case in which an article M is to be transported from a first load port 91a, the system controller 5 performs the following transport-instruction dividing process. Specifically, a first divided transport instruction, which is a transport instruction to transport an article M from the first load port 91a to the delivery buffer 92, is assigned to a transport vehicle V present on the first intra-bay rail RX1, and a second divided transport instruction, which is a transport instruction to transport the article M from the delivery buffer 92, is assigned to a transport vehicle V present on a rail other than the first intra-bay rail RX1. The traffic restriction in this case may be a case in which the active ratio of the exit area OA is the certain ratio or less. The first divided transport instruction and the second divided transport instruction may be determined by dividing one transport instruction into a plurality of transport instructions with the delivery buffer 92 used as a relay point such that, for example, the sums of distances and cost times thereof are minimized.

At the time of traffic restriction in the case in which an article M is to be transported to a first load port 91a, the system controller 5 performs the following transport-instruction dividing process. Specifically, a first divided transport instruction to transport an article M to the delivery buffer 92 is assigned to a transport vehicle V present on a rail other than the first intra-bay rail RX1, and a second divided transport instruction to transport the article M from the delivery buffer 92 to the first load port 91a is assigned to a transport vehicle V present on the first intra-bay rail RX1. In this case, the time of traffic restriction may be time of traffic restriction in a case in which the active ratio of the entrance area IA is the certain ratio or less.

In a case in which an article M is to be transported from a first load port 91a or an article M is to be transported to the first load port 91a, at the time of traffic restriction in the first intra-bay rail RX1, the system controller 5 performs an entry/exit restriction process of restricting entry and exit of transport vehicles V into and from the first intra-bay rail RX1 such that the number of transport vehicles V present on the first intra-bay rail RX1 becomes closer to a predetermined number of vehicles (e.g., one) set in advance.

For example, in the entry/exit restriction process, in a case in which traffic restriction of the predetermined level or more is occurring in the entrance area IA of the first intra-bay rail RX1, exit of transport vehicles V from the first intra-bay rail RX1 is controlled such that the number of transport vehicles V present on the first intra-bay rail RX1 does not become less than the predetermined number. In the entry/exit restriction process, in a case in which traffic restriction of the predetermined level or more is occurring in the exit area OA of the first intra-bay rail RX1, entry of transport vehicles V into the first intra-bay rail RX1 is controlled such that the number of transport vehicles V present on the first intra-bay rail RX1 does not become more than the predetermined number. After performing this entry/exit restriction process, the system controller 5 performs the above-described transport-instruction dividing process of dividing and assigning the transport instruction to a plurality of transport vehicles V.

Herein, the "transport-instruction dividing process" and the "entry/exit restriction process" described above are used similarly when the second load port 91b of the second intra-bay rail RX2 is used as the transport source and destination, and are used similarly when the third load port 91c of the third intra-bay rail RX3 is used as the transport source and destination. When the second load port 91b is used as the transport source and destination, the second intra-bay rail RX2 corresponds to the first intra-section track and the second load port 91b corresponds to the first loading portion. When the third load port 91c is used as the transport source and destination, the third intra-bay rail RX3 corresponds to the first intra-section track and the third load port 91c corresponds to the first loading portion.

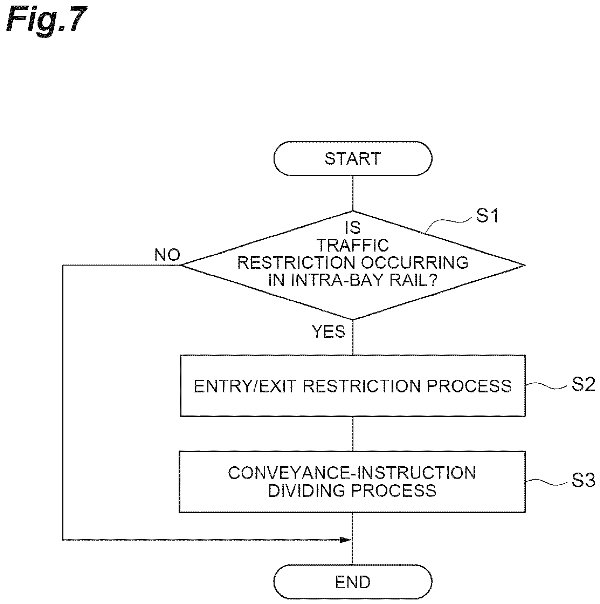

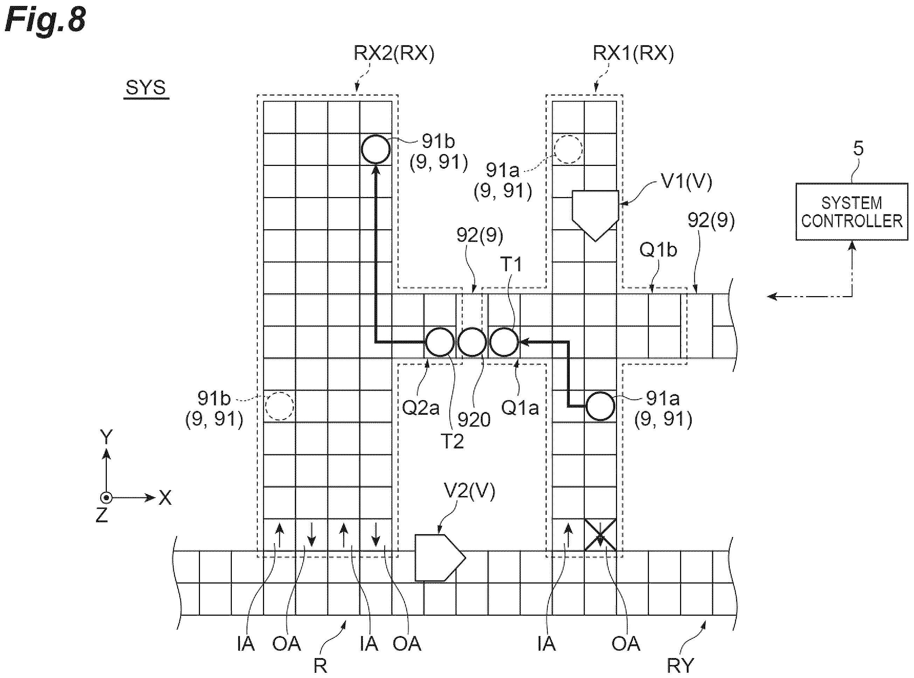

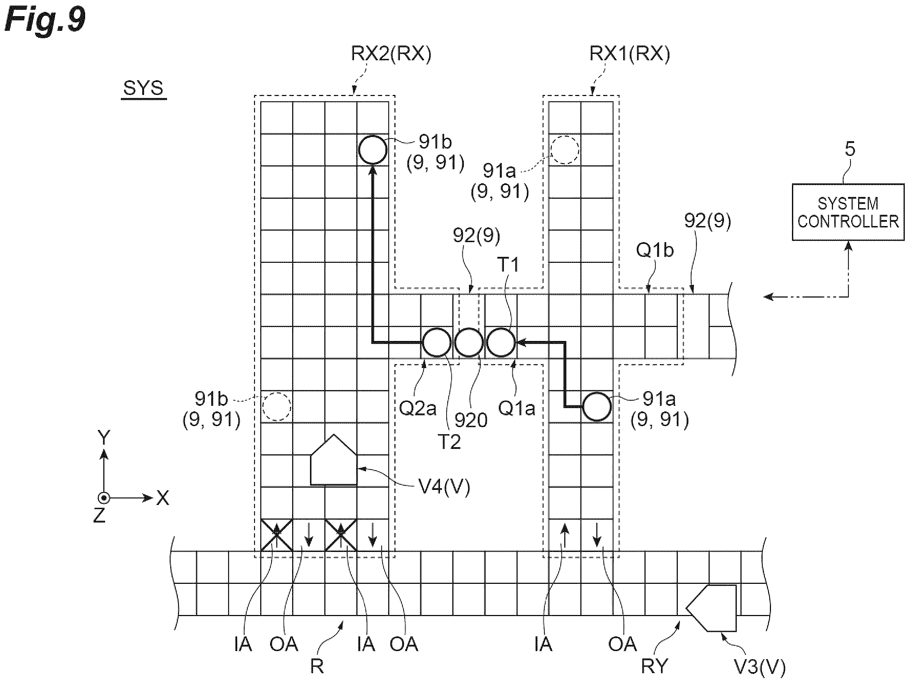

FIG. 7 is a flowchart illustrating an example of processes to be performed by the system controller 5 in the transport system SYS. FIG. 8 is a schematic plan view for describing the processes illustrated in FIG. 7 in the transport system SYS. FIG. 9 is another schematic plan view for describing the processes illustrated in FIG. 7 in the transport system SYS. In the transport system SYS, for example, when a transport instruction to transport an article M from a first load port 91a of the first intra-bay rail RX1 to a second load port 91b of the second intra-bay rail RX2 is assigned to a transport vehicle V, the following process is performed.

Specifically, as illustrated in FIG. 7, to begin with, the system controller 5 determines whether traffic restriction is occurring in the intra-bay rail RX (step S1). At this step S1, in at least one of the first intra-bay rail RX1 corresponding to a transport source and the second intra-bay rail RX2 corresponding to a transport destination, it is determined whether traffic restriction is occurring in at least one of the entrance areas IA and the exit areas OA. If NO at the step S1, the processes end without performing anything and a transport instruction is assigned to a transport vehicle V as appropriate. If YES at the step S1, the system controller 5 performs the entry/exit restriction process for the intra-bay rail RX where traffic restriction is occurring (step S2).

After the step S2, the system controller 5 performs the transport-instruction dividing process of dividing the transport instruction into a plurality of instructions and assigning them to a plurality of transport vehicles V (step S3). At the step S3, the initial transport instruction is divided into a first divided transport instruction to transport the article M from the first load port 91a to the delivery buffer 92 and a second divided transport instruction to transport the article M from the delivery buffer 92 to the second load port 91b. The first divided transport instruction is then assigned to a transport vehicle V, and the second divided transport instruction is assigned to another transport vehicle V.

By the above processes, as illustrated in FIG. 8, for example, in an example in which traffic restriction is occurring in the exit area OA of the first intra-bay rail RX1, the first divided transport instruction divided with the delivery buffer 92 used as a relay point is assigned to a transport vehicle V1 present on the first intra-bay rail RX1. Consequently, the transport vehicle V1 proceeds to directly above the first load port 91a, loads the article M thereon from the first load port 91a, then enters the delivery rail Q1a, and stops at a position T1 in front of the delivery buffer 92 at the delivery rail Q1a. The transport vehicle V1 unloads the article M therefrom onto the shelf 920 of the delivery buffer 92 by causing the lateral feed mechanism 11 to slide and move the lifting drive unit 14 and the article holding unit 13.

The other second divided transport instruction divided with the delivery buffer 92 used as a relay point is then assigned to another transport vehicle V2 that is not present on the first intra-bay rail RX1. Consequently, the transport vehicle V2 enters the delivery rail Q2a of the second intra-bay rail RX2 and stops at a position T2 in front of the delivery buffer 92 at the delivery rail Q2a. The transport vehicle V2 loads the article M thereon from the shelf 920 of the delivery buffer 92 by causing the lateral feed mechanism 11 to slide and move the lifting drive unit 14 and the article holding unit 13. The transport vehicle V2 then proceeds to directly above the second load port 91b and unloads the article M therefrom onto the second load port 91b.

Similarly, as illustrated in FIG. 9, for example, in an example in which traffic restriction is occurring in the entrance areas IA of the second intra-bay rail RX2, the divided first divided transport instruction is assigned to a transport vehicle V3 that is not present on the second intra-bay rail RX2. Consequently, the transport vehicle V3 proceeds to directly above the first load port 91a, loads the article M thereon from the first load port 91a, then enters the delivery rail Q1a, stops at the position T1 in front of the delivery buffer 92 at the delivery rail Q1a, and unloads the article M therefrom onto the shelf 920 of the delivery buffer 92. The divided second divided transport instruction is then assigned to another transport vehicle V4 present on the second intra-bay rail RX2. Consequently, the transport vehicle V4 enters the delivery rail Q2a of the second intra-bay rail RX2, stops at the position T2 in front of the delivery buffer 92 at the delivery rail Q2a, loads the article M thereon from the shelf 920 of the delivery buffer 92, then proceeds to directly above the second load port 91b, and unloads the article M therefrom onto the second load port 91b.

As described above, in the transport system SYS, even at the time of traffic restriction in at least one of the entrance areas IA and the exit areas OA of the intra-bay rail RX, the transport of an article from the intra-bay rail RX and to the intra-bay rail RX can be smoothly performed via the delivery buffer 92. This can improve the efficiency of transporting articles M.

In the transport system SYS, at the time of traffic restriction in the intra-bay rail RX, the transport instruction is divided and assigned to a plurality of transport vehicles V. By this control, smooth transport of articles M at the time of traffic restriction in the intra-bay rail RX can be specifically performed.

In the transport system SYS, at the time of traffic restriction in the first intra-bay rail RX1 in a case in which an article M is to be transported from the first load port 91a, the system controller 5 assigns the first divided transport instruction to transport the article M from the first load port 91a to the delivery buffer 92 to a transport vehicle V1 present on the first intra-bay rail RX1, and also assigns the second divided transport instruction to transport the article M from the delivery buffer 92 to another transport vehicle V2 present on a rail other than the first intra-bay rail RX1. In this case, at the time of traffic restriction in the first intra-bay rail RX1, the transport instruction is divided into the first divided transport instruction and the second divided transport instruction, and the respective instructions are assigned to the two different transport vehicles V1 and V2, whereby the transport of the article M from the first load port 91a can be performed.

In the transport system SYS, at the time of traffic restriction in the second intra-bay rail RX2 in a case in which an article M is to be transported to the second load port 91b, the system controller 5 assigns the first divided transport instruction to transport the article M to the delivery buffer 92 to a transport vehicle V3 present on a rail other than the second intra-bay rail RX2, and also assigns the second divided transport instruction to transport the article M from the delivery buffer 92 to the second load port 91b to another transport vehicle V4 present on the second intra-bay rail RX2. In this case, at the time of traffic restriction in the second intra-bay rail RX2, the transport instruction is divided into the first divided transport instruction and the second divided transport instruction, and the respective instructions are assigned to the two transport vehicles V3 and V4, whereby the transport of the article M to the second load port 91b can be performed.

In the transport system SYS, a plurality of the intra-bay rails RX are disposed side by side in one direction, and the first intra-bay rail RX1 and the second intra-bay rail RX2 are adjacent to each other. In this case, the transport of an article M via the delivery buffer 92 can be performed between the first intra-bay rail RX1 and the second intra-bay rail RX2 that are disposed side by side so as to be adjacent to each other in one direction.

In the transport system SYS, each transport vehicle V includes the transfer device 18 including: the article holding unit 13 configured to hold an article M; the lifting drive unit 14 configured to raise and lower the article holding unit 13; and the lateral feed mechanism 11 configured to slide and move the lifting drive unit 14 in the horizontal direction. The transport vehicle V transfers an article M onto and from the shelf 920 of the delivery buffer 92 by causing the lateral feed mechanism 11 to slide and move the lifting drive unit 14 and the article holding unit 13. In this case, the article M can be transferred onto and from a loading portion 9 horizontally away from the intra-bay rail RX.

In the transport system SYS, the rail R is a grid-patterned track. In this case, what is called a grid system can be configured. By this configuration, traveling paths for the transport vehicle V can be selected easily and flexibly, whereby traffic congestion can be prevented and transport efficiency can be further improved.

In the transport system SYS, each entrance area IA corresponds to a grid cell 2 of the intra-bay rail RX that is passed through when the intra-bay rail RX is entered, and each exit area OA corresponds to a grid cell 2 of the intra-bay rail RX that is passed through when the intra-bay rail RX is exited. The system controller 5 determines the level of traffic restriction on the basis of the ratio of the number of available grid cells 2 among all grid cells 2 corresponding to the entrance areas IA and the ratio of the number of available grid cells 2 among all grid cells 2 corresponding to the exit areas OA. In this case, whether traffic restriction is occurring in the intra-bay rail RX in the grid system can be specifically determined.

In the transport system SYS, in a case in which an article M is to be transported from a load port 91 or the article M is to be transported to the load port 91, when traffic restriction is occurring in the intra-bay rail RX in which transport vehicles V are present at the time of transfer to the load port 91, the system controller 5 performs the entry/exit restriction process of restricting entry and exit of the transport vehicles V into and from the intra-bay rail RX such that the number of the transport vehicles V present on the intra-bay rail RX becomes closer to a predetermined number. After performing the entry/exit restriction process, the system controller 5 performs the transport-instruction dividing process. By this control, while the number of transport vehicles V present on the intra-bay rail RX where traffic restriction is occurring is being controlled, the article can be transported from the load port 91 of the intra-bay rail RX where traffic restriction is occurring via the delivery buffer 92, and the article M can be transported to the load port 91 via the delivery buffer 92.

In the transport system SYS, the first intra-bay rail RX1 includes the delivery rail Q1a and the second intra-bay rail RX2 includes the delivery rail Q2a. Onto and from the delivery buffer 92 between the first intra-bay rail RX1 and the second intra-bay rail RX2, not only a transport vehicle V present on the delivery rail Q1a but also a transport vehicle V present on the delivery rail Q2a can transfer an article M. In this case, by using the delivery rails Q1a and Q2a, the article M can be transported via the delivery buffer 92. Similarly, the first intra-bay rail RX1 includes the delivery rail Q1b, and the third intra-bay rail RX3 includes the delivery rail Q3a. Onto and from the delivery buffer 92 between the first intra-bay rail RX1 and the third intra-bay rail RX3, not only a transport vehicle V present on the delivery rail Q1b but also a transport vehicle V present on the delivery rail Q3a can transfer an article M. In this case, by using the delivery rails Q1b and Q3a, the article M can be transported via the delivery buffer 92. Herein, the delivery buffer 92 serves as a backup for the loading portion 9 and is used when a transport instruction is divided, and is not used in normal operation.

Although the embodiment has been described above, an aspect of the present invention is not limited to the embodiment, and various modifications may be made within the scope not departing from the gist of the invention.

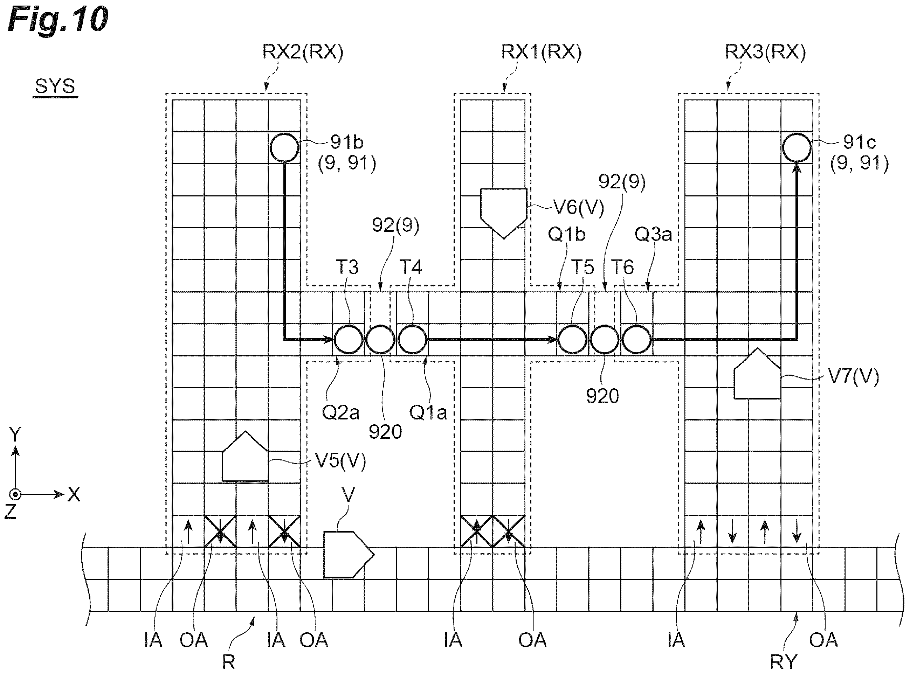

In the above embodiment, for example, as illustrated in FIG. 10, in a case in which an article M is to be transported from a second load port 91b of the second intra-bay rail RX2 to a third load port 91c of the third intra-bay rail RX3, when traffic restriction is occurring in the first intra-bay rail RX1 and the second intra-bay rail RX2, the transport instruction may be divided and assigned to a plurality of transport vehicles V as follows.

To begin with, a first divided transport instruction is assigned to a transport vehicle V5 present on the second intra-bay rail RX2. Consequently, the transport vehicle V5 proceeds to directly above the second load port 91b, loads the article M thereon from the second load port 91b, then enters the delivery rail Q2a, stops at a position T3 in front of the delivery buffer 92 at the delivery rail Q2a, and unloads the article M therefrom onto the shelf 920 of the delivery buffer 92. A second divided transport instruction is assigned to a transport vehicle V6 present on the first intra-bay rail RX1. Consequently, the transport vehicle V6 enters the delivery rail Q1a of the first intra-bay rail RX1, stops at a position T4 in front of the delivery buffer 92 at the delivery rail Q1a, loads the article M thereon from the shelf 920 of the delivery buffer 92, then enters the delivery rail Q1b, stops at a position T5 in front of the delivery buffer 92 at the delivery rail Q1b, and unloads the article M therefrom onto the shelf 920 of the delivery buffer 92.

A third divided transport instruction is then assigned to a transport vehicle V7 present on the third intra-bay rail RX3. Consequently, the transport vehicle V7 enters the delivery rail Q3a of the third intra-bay rail RX3, stops at a position T6 in front of the delivery buffer 92 at the delivery rail Q3a, loads the article M thereon from the delivery buffer 92, then proceeds to directly above the third load port 91c, and unloads the article M therefrom onto the third load port 91c.

Thus, in the above embodiment, in a case in which an article M is to be transported from the second load port 91b, when traffic restriction is occurring in the first intra-bay rail RX1 and the second intra-bay rail RX2, the system controller 5 may divide and assign, to a plurality of transport vehicles V, a transport instruction to transport the article M from the second load port 91b via the delivery buffer 92 between the first intra-bay rail RX1 and the second intra-bay rail RX2 and the delivery buffer 92 between the first intra-bay rail RX1 and the third intra-bay rail RX3. In this case, even at the time of traffic restriction in the first intra-bay rail RX1 and the second intra-bay rail RX2, the article M can be transported via the respective delivery buffers 92 among the first intra-bay rail RX1, the second intra-bay rail RX2, and the third intra-bay rail RX3. In this case, the second load port 91b corresponds to the first loading portion, the delivery buffers 92 correspond to the second and third loading portions, the second intra-bay rail RX2 corresponds to the first intra-section track, the first intra-bay rail RX1 corresponds to the second intra-section track, and the third intra-bay rail RX3 corresponds to the third intra-section track.

In the above embodiment, in a case in which an article M is to be transported to the third load port 91c, at the time of traffic restriction in the first intra-bay rail RX1 and the third intra-bay rail RX3, the system controller 5 may divide and assign, to a plurality of transport vehicles V, a transport instruction to transport the article M to the third load port 91c via the delivery buffer 92 between the first intra-bay rail RX1 and the second intra-bay rail RX2 and the delivery buffer 92 between the first intra-bay rail RX1 and the third intra-bay rail RX3. In this case, even at the time of traffic restriction in the first intra-bay rail RX1 and the third intra-bay rail RX3, the article M can be transported via the respective delivery buffers 92 among the first intra-bay rail RX1, the second intra-bay rail RX2, and the third intra-bay rail RX3. In this case, the third load port 91c corresponds to the first loading portion, the delivery buffers 92 correspond to the second and third loading portions, the third intra-bay rail RX3 corresponds to the first intra-section track, the first intra-bay rail RX1 corresponds to the second intra-section track, and the second intra-bay rail RX2 corresponds to the third intra-section track.

In the above embodiment, the intra-bay rail RX includes the first to third intra-bay rails RX1, RX2, and RX3. However, it may include another intra-bay rail RX, that is, the rail R may include four or more intra-bay rails RX. The rail R only needs to include a plurality of the intra-bay rails RX. In the above embodiment, each load port 91 is disposed directly below the intra-bay rail RX. However, it may be disposed laterally away from the intra-bay rail RX in plan view.

In the above embodiment, the grid system is adopted as the transport system SYS. However, the transport system SYS is not limited to the grid system. For example, as the transport system, automated guided vehicles (AGVs) may be adopted, or various known systems configured to travel on a grid-patterned traveling path may be adopted. In the above embodiment, the transport vehicle V holds an article M below the rail R. However, the body section 10 may be disposed above the rail R and hold an article M above the rail R. In the above embodiment, the second loading portion is not limited to the overhead buffer, and may be various types of loading portions as long as an article M can be placed thereon. In the above embodiment, the delivery rails Q1a, Q1b, Q2a, Q3a are used for delivering and receiving articles M via the delivery buffers 92. However, they may also be used as areas for the transport vehicle V to temporarily wait or retreat.

In the above embodiment, the controller generates a plurality of divided transport instructions by dividing the initial transport instruction. However, it may also generate the divided transport instructions without using the initial transport instruction. Specifically, in the above embodiment, in the case in which an article is to be transported from the first loading portion or the article is to be transported to the first loading portion, at the time of traffic restriction in the first intra-section track, the controller may cause a plurality of transport vehicles to perform transport for transporting the article from the first loading portion via the second loading portion or transport for transporting the article to the first loading portion via the second loading portion. In other words, in the above embodiment, the transport vehicles may be caused to transport the article from the first loading portion or to the first loading portion via the second loading portion. Transport to the second loading portion and transport from the second loading portion may be performed by different transport vehicles. In this case, the above effects are still obtained.

Similarly, in the above embodiment, in the case in which an article is to be transported from the first loading portion or the article is to be transported to the first loading portion, when traffic restriction is further occurring in the second intra-section track at the time of traffic restriction in first intra-section track, the controller may cause a plurality of transport vehicles to perform transport for transporting the article from the first loading portion via the second loading portion and the third loading portion or transport for transporting the article to the first loading portion via the second loading portion and the third loading portion. In other words, in the above embodiment, the transport vehicles may be caused to transport the article from the first loading portion or to the first loading portion via the second loading portion and the third loading portion. Transport to the second loading portion, transport from the second loading portion, transport to the third loading portion, and transport from the third loading portion may be performed by different transport vehicles. In this case, the above effects are still obtained.

The materials and shapes of the respective configurations in the embodiment and the modifications above are not limited to those described above, and various materials and shapes can be used. Each configuration in the embodiment or the modifications above may be optionally applied to each configuration in other embodiments or modifications. Some of the respective configurations in the embodiment or the modifications above may be omitted as appropriate within the scope not departing from the gist of an aspect of the present invention.

### Reference Signs List

2 ... grid cell
5 ... system controller (controller)
9 ... loading portion
11 ... lateral feed mechanism
13 ... article holding unit
14 ... lifting drive unit
91 ... load port (first loading portion)
91a ... first load port (first loading portion)
91b ... second load port (first loading portion)
91c ... third load port (first loading portion)
92 ... delivery buffer (second and third loading portions)
IA ... entrance area
M ... article
OA ... exit area
Q1a, Q1b, Q2a, Q3a ... rail for non-normal operation (track for non-normal operation)
R ... rail (traveling track, grid-patterned track)
RX ... intra-bay rail (intra-section track)
RX1 ... first intra-bay route (first and second intra-section tracks)
RX2 ... second intra-bay route (first to third intra-section tracks)
RX3 ... third intra-bay route (first to third intra-section tracks)
RY ... inter-bay route (connecting track)
SYS ... transport system
V, V1, V2, V3, V4, V5, V6, V7 ... transport vehicle

## Claims

1. A transport system comprising:
a plurality of transport vehicles each configured to transport an article;
a traveling track on which the transport vehicles travel;
a loading portion on which the article is placed; and
a controller to control the transport vehicles, wherein
the traveling track includes a plurality of intra-section tracks and a connecting track connecting the intra-section tracks,
each of the intra-section tracks includes an entrance area for entering the intra-section track and an exit area for exiting the intra-section track,
the loading portion includes:
a first loading portion being the loading portion onto and from which the transport vehicle present on a first intra-section track of the intra-section tracks is able to transfer the article; and
a second loading portion being the loading portion onto and from which the transport vehicle present on the first intra-section track is able to transfer the article and also onto and from which the transport vehicle present on a second intra-section track of the intra-section tracks is able to transfer the article, and
in a case in which the article is to be transported from the first loading portion or the article is to be transported to the first loading portion, at the time of traffic restriction in which traffic restriction of a predetermined level or more is occurring in at least one of the entrance area and the exit area of the first intra-section track, the controller causes the transport vehicles to perform transport for transporting the article from the first loading portion via the second loading portion or transport for transporting the article to the first loading portion via the second loading portion.

2. The transport system according to claim 1, wherein
at the time of traffic restriction in the case in which the article is to be transported from the first loading portion or the article is to be transported to the first loading portion, the controller divides and assigns, to the transport vehicles, a transport instruction to transport the article from the first loading portion via the second loading portion or a transport instruction to transport the article to the first loading portion via the second loading portion.

3. The transport system according to claim 1, wherein
at the time of traffic restriction in the case in which the article is to be transported from the first loading portion, the controller assigns a transport instruction to transport the article from the first loading portion to the second loading portion to the transport vehicle present on the first intra-section track, and also assigns a transport instruction to transport the article from the second loading portion to the transport vehicle present on a track other than the first intra-section track.

4. The transport system according to claim 1, wherein
at the time of traffic restriction in the case in which the article is to be transported to the first loading portion, the controller assigns a transport instruction to transport the article to the second loading portion to the transport vehicle present on a track other than the first intra-section track, and also assigns a transport instruction to transport the article from the second loading portion to the first loading portion to the transport vehicle present on the first intra-section track.

5. The transport system according to claim 1, wherein
the intra-section tracks are disposed side by side in one direction, and
the first intra-section track and the second intra-section track are adjacent to each other.

6. The transport system according to claim 1, wherein
each transport vehicle
includes a transfer device including: an article holding unit configured to hold the article; a lifting drive unit configured to raise and lower the article holding unit; and a lateral feed mechanism configured to slide and move the lifting drive unit in a horizontal direction, and
transfers the article onto and from the second loading portion by causing the lateral feed mechanism to slide and move the lifting drive unit and the article holding unit.

7. The transport system according to claim 1, wherein the traveling track is a grid-patterned track.

8. The transport system according to claim 7, wherein
the entrance area corresponds to a grid cell in the first intra-section track that is passed through when the first intra-section track is entered,
the exit area corresponds to a grid cell in the first intra-section track that is passed through when the first intra-section track is exited, and
the controller determines a level of traffic restriction based on a ratio of the number of available grid cells corresponding to the entrance area to the number of all grid cells corresponding to the entrance area and a ratio of the number of available grid cells corresponding to the exit area to the number of all grid cells corresponding to the exit area.

9. The transport system according to claim 1, wherein
the loading portion includes a third loading portion being the loading portion onto and from which the transport vehicle present on the second intra-section track is able to transfer the article and also onto and from which the transport vehicle present on a third intra-section track of the intra-section tracks is able to transfer the article, and
in the case in which the article is to be transported from the first loading portion or the article is to be transported to the first loading portion, when traffic restriction of a predetermined level or more is further occurring in at least one of the entrance area and the exit area of the second intra-section track at the time of traffic restriction, the controller causes the transport vehicles to perform transport for transporting the article from the first loading portion via the second loading portion and the third loading portion or transport for transporting the article to the first loading portion via the second loading portion and the third loading portion.

10. The transport system according to claim 1, wherein
at the time of traffic restriction in the case in which the article is to be transported from the first loading portion or the article is to be transported to the first loading portion, the controller
performs an entry/exit restriction process of restricting entry and exit of the transport vehicles into and from the first intra-section track such that the number of the transport vehicles present on the first intra-section track becomes closer to a predetermined number set in advance, and
after performing the entry/exit restriction process, causes the transport vehicles to perform the transport for transporting the article from the first loading portion via the second loading portion or the transport for transporting the article to the first loading portion via the second loading portion.

11. The transport system according to claim 1, wherein
the first intra-section track includes a delivery track disposed to extend towards the second intra-section track in plan view,
the second intra-section track includes a delivery track disposed to extend towards the first intra-section track in plan view, and
the second loading portion is the loading portion onto and from which the transport vehicle present on the delivery track of the first intra-section track is able to transfer the article and also onto and from which the transport vehicle present on the delivery track of the second intra-section track is able to transfer the article.
